(19) Europäisches Patentamt / European Patent Office / Office européen des brevets

(11) **EP 4 403 934 A1**

(12) **EUROPEAN PATENT APPLICATION**
published in accordance with Art. 153(4) EPC

(43) Date of publication:
24.07.2024 Bulletin 2024/30

(21) Application number: 22866553.5

(22) Date of filing: 05.09.2022

(51) International Patent Classification (IPC):
*G01R 29/02* (2006.01)    *G01R 23/10* (2006.01)

(86) International application number:
PCT/CN2022/117112

(87) International publication number:
WO 2023/036090 (16.03.2023 Gazette 2023/11)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 13.09.2021 CN 202111070278

(71) Applicant: Beijing CHJ Information Technology
Co., Ltd.
Beijing 101399 (CN)

(72) Inventor: SHAO, Hongshan
Beijing 101399 (CN)

(74) Representative: Maiwald GmbH
Elisenhof
Elisenstraße 3
80335 München (DE)

(54) **PULSE WIDTH MODULATION SIGNAL ACQUISITION METHOD AND APPARATUS, COMPUTER DEVICE, AND STORAGE MEDIUM**

(57)     A pulse width modulation signal acquisition method and apparatus, a computer device, and a storage medium. The method comprises: obtaining an initial count value within a pulse width modulation signal pulse period on the basis of an initial frequency division coefficient (S110); determining a predicted frequency of a pulse width modulation signal according to the initial count value in the pulse width modulation signal pulse period (S120); determining a corresponding target frequency division coefficient according to the predicted frequency of the pulse width modulation signal (S130); and obtaining a target count value within the pulse width modulation signal pulse period and a target count value within a pulse width modulation signal pulse width time on the basis of the target frequency division coefficient, determining an actual frequency of the pulse width modulation signal according to the target count value within the pulse width modulation signal pulse period, and determining an actual duty cycle of the pulse width modulation signal on the basis of the target count value within the pulse width modulation signal pulse period and the target count value within the pulse width modulation signal pulse width time (S140).

```
┌─────────────────────────────────────────────────────────┐
│ acquiring an initial count value during a pulse period   │ ⌐ S110
│ of the PWM signal is acquired based on an initial        │
│ frequency division coefficient                           │
└─────────────────────────────────────────────────────────┘
                          ↓
┌─────────────────────────────────────────────────────────┐
│ determining a predicted frequency of the PWM signal      │ ⌐ S120
│ based on the initial count value during the pulse period │
│ of the PWM signal                                        │
└─────────────────────────────────────────────────────────┘
                          ↓
┌─────────────────────────────────────────────────────────┐
│ determining a corresponding target frequency division    │ ⌐ S130
│ coefficient based on the predicted frequency of the PWM  │
│ signal                                                   │
└─────────────────────────────────────────────────────────┘
                          ↓
┌─────────────────────────────────────────────────────────┐
│ acquiring a target count value during the pulse period   │ ⌐ S140
│ of the PWM signal and a target count value during a      │
│ pulse width time of the PWM signal based on the target   │
│ frequency division coefficient, determining an actual    │
│ frequency of the PWM signal based on the target count    │
│ value during the pulse period of the PWM signal, and     │
│ determining an actual duty ratio of the PWM signal based │
│ on the target count value during the pulse period of the │
│ PWM signal and the target count value during the pulse   │
│ width time of the PWM signal                             │
└─────────────────────────────────────────────────────────┘

                        FIG. 1
```

# Description

## CROSS-REFERENCE TO RELATED APPLICATIONS

This application is based on and claims priority to Patent Application No. 202111070278.2, filed on September 13, 2021, the entire contents of which are incorporated herein by reference.

## TECHNICAL FIELD

The present disclosure relates to a field of automobile technologies, specifically to a method and an apparatus for acquiring a pulse width modulation (PWM) signal, a computer device, a computer-readable storage medium, a computer program product and a computer program.

## BACKGROUND

A pulse width modulation (PWM) signal technology is widely applied in various fields such as industrial automation, precision computer numerical control (CNC) machine tools, photoelectric instruments and aerospace. Key parameters for acquisition and measurement of a PWM signal wave are a duty cycle and a frequency.

Currently, acquisition of a duty ratio and a frequency of the PWM signal is generally calculated by capturing count values of a rising edge and a falling edge of the PWM signal by an input capture unit (ICU) integrated in a microcontroller (MCU). For example, a period of the PWM signal is calculated by recording a count value between two adjacent rising edges in the PWM signal, and the duty ratio is calculated by recording a count value between the rising edge and the falling edge of the PWM signal. Since a fixed frequency division coefficient is adopted during counting and the counting is limited by a bit number of a timer of the ICU module, when a highfrequency PWM signal is acquired, the count value is inaccurate, an acquisition frequency will be jittered, and the jitter will be larger as the frequency is higher. Therefore, in the related art, the PWM signal in a wide frequency range cannot be accurately acquired.

## SUMMARY

A method and an apparatus for acquiring a pulse width modulation (PWM) signal, a computer device, a computer-readable storage medium, a computer program product and a computer program are provided in at least one embodiment of the disclosure.

In a first aspect, a method for acquiring a pulse width modulation (PWM) signal is provided according to embodiments of the present disclosure, and includes:

acquiring an initial count value during a pulse period of the PWM signal based on an initial frequency division coefficient;

determining a predicted frequency of the PWM signal based on the initial count value during the pulse period of the PWM signal;
determining a corresponding target frequency division coefficient based on the predicted frequency of the PWM signal; and
acquiring a target count value during the pulse period of the PWM signal and a target count value during a pulse width time of the PWM signal based on the target frequency division coefficient, determining an actual frequency of the PWM signal based on the target count value during the pulse period of the PWM signal, and determining an actual duty ratio of the PWM signal based on the target count value during the pulse period of the PWM signal and the target count value during the pulse width time of the PWM signal.

In some embodiments, the initial frequency division coefficient is determined based on an intermediate frequency of an acquisition frequency band of the PWM signal and a frequency of a clock source.
In some embodiments, the initial frequency division coefficient is determined based on an equation:

$$Div0 = f1/(f2*N);$$

where f1 is a frequency of a clock source, f2 is an intermediate frequency of an acquisition frequency band of the PWM signal, DivO is an initial frequency division coefficient, and N is a maximum count value of a timer.
In some embodiments, before acquiring the initial count value during the pulse period of the PWM signal based on the initial frequency division coefficient, the method further includes:
triggering to execute an operation of acquiring the initial count value during the pulse period of the PWM signal based on the initial frequency division coefficient in response to detecting an input of the PWM signal.
In some embodiments, after detecting the input of the PWM signal, the method further includes:
triggering to execute the operation of acquiring the initial count value during the pulse period of the PWM signal based on the initial frequency division coefficient in response to determining that count does not overflow.
In some embodiments, determining the corresponding target frequency division coefficient based on the predicted frequency of the PWM signal includes:

determining a frequency band to which the predicted frequency of the PWM signal belongs; and
determining a frequency division coefficient corresponding to the frequency band to which the predicted frequency of the PWM signal belongs as the target frequency division coefficient of the PWM signal.

In some embodiments, before determining the frequency division coefficient corresponding to the frequency band to which the predicted frequency of the PWM signal belongs as the target frequency division coefficient of the PWM signal, the method includes:

triggering an operation of determining the frequency division coefficient corresponding to the frequency band to which the predicted frequency of the PWM signal belongs as the target frequency division coefficient of the PWM signal in response to determining that the frequency division coefficient corresponding to the frequency band to which the predicted frequency of the PWM signal belongs is different from the initial frequency division coefficient.

In some embodiments, acquiring the target count value during the pulse period of the PWM signal and the target count value during the pulse width time of the PWM signal based on the target frequency division coefficient, determining the actual frequency of the PWM signal based on the target count value during the pulse period of the PWM signal, and determining the actual duty ratio of the PWM signal based on the target count value during the pulse period of the PWM signal and the target count value during the pulse width time of the PWM signal includes:

acquiring the target count value during the pulse period of the PWM signal and the target count value during the pulse width time of the PWM signal based on the target frequency division coefficient; and

discarding a target count value during the pulse period of the PWM signal acquired based on the target frequency division coefficient for a first time and a target count value during the pulse width time of the PWM signal acquired based on the target frequency division coefficient for a first time, determining the actual frequency of the PWM signal based on a target count value during the pulse period of the PWM signal acquired based on the target frequency division coefficient for a second time, and determining the actual duty ratio of the PWM signal based on the target count value during the pulse period of the PWM signal and the target count value during the pulse width time of the PWM signal acquired based on the target frequency division coefficient for the second time.

In some embodiments, acquiring the target count value during the pulse period of the PWM signal and the target count value during the pulse width time of the PWM signal based on the target frequency division coefficient, determining the actual frequency of the PWM signal based on the target count value during the pulse period of the PWM signal, and determining the actual duty ratio of the PWM signal based on the target count value during the pulse period of the PWM signal and the target count value during the pulse width time of the PWM signal includes:

acquiring the target count value during the pulse period of the PWM signal and the target count value during the pulse width time of the PWM signal based on the target frequency division coefficient;

acquiring the actual duty ratio of the PWM signal determined based on the target count value during the pulse period of the PWM signal acquired based on the target frequency division coefficient for the first time; and

in response to a difference value between the actual frequency of the PWM signal and the predicted frequency of the PWM signal being greater than a preset threshold, determining the actual frequency of the PWM signal based on a target count value during the pulse period of the PWM signal acquired based on the target frequency division coefficient for the second time, and determining the actual duty ratio of the PWM signal based on the target count value during the pulse period of the PWM signal and a target count value during the pulse width time of the PWM signal acquired based on the target frequency division coefficient for the second time.

In a second aspect, an apparatus for acquiring a pulse width modulation (PWM) signal is provided according to embodiments of the present disclosure, and includes:

an initial count value acquiring module, configured to acquire an initial count value during a pulse period of the PWM signal based on an initial frequency division coefficient;

a frequency prediction module, configured to determine a predicted frequency of the PWM signal based on the initial count value during the pulse period of the PWM signal;

a target frequency division coefficient determining module, configured to determine a corresponding target frequency division coefficient based on the predicted frequency of the PWM signal; and

an actual frequency and actual duty radio determining module, configured to acquire a target count value during the pulse period of the PWM signal and a target count value during a pulse width time of the PWM signal based on the target frequency division coefficient, determine an actual frequency of the PWM signal based on the target count value during the pulse period of the PWM signal, and determine an actual duty ratio of the PWM signal based on the target count value during the pulse period of the PWM signal and the target count value during the pulse width time of the PWM signal.

In a third aspect, a computer device including one or more processors and a storage device is further provided according to embodiments of the disclosure; in which the storage device is configured to store one or more programs, in which when the one or more programs are executed by the one or more processors, the one or more processors are caused to implement the method for acquiring the PWM signal as described in the first aspect of any embodiment.

In a fourth aspect, a computer-readable storage medium with a computer program computer program stored thereon is provided according to embodiments of the disclosure. The computer program implements the method for acquiring the PWM signal as described in the first aspect of any embodiment of the present disclosure when executed by a processor.

In a fifth aspect, a computer program product including a computer program is further provided according to embodiments of the disclosure, and when the computer program is executed by a processor, the method for acquiring the PWM signal as described in the first aspect of any embodiment of the present disclosure is implemented.

In a sixth aspect, a computer program including a computer program code is further provided according to embodiments of the disclosure. When the computer program code is running on a computer, the computer is caused to perform the method for acquiring the PWM signal as described in the first aspect of any embodiment of the present disclosure.

It can be seen that, in at least one embodiment of the disclosure, the present disclosure may self-adaptively adjust the frequency division coefficient based on the frequency of the inputted PWM signal, acquire the target count value during the pulse period of the PWM signal and the target count value during the pulse width time of the PWM signal based on the adjusted frequency division coefficient, and determine the actual frequency of the PWM signal based on the target count value during the pulse period of the PWM signal, and determine the actual duty ratio of the PWM signal based on the target count value during the pulse period of the PWM signal and the target count value during the pulse width time of the PWM signal. Since, for the inputted PWM signal, the present disclosure may self-adaptively adjust the target frequency division coefficient based on the frequency of the inputted PWM signal, the accurate target count value during the pulse period of the PWM signal and the accurate target count value during the pulse width time of the PWM signal may be acquired based on the target frequency division coefficient corresponding to the PWM signal, which avoids a problem of an inaccurate count value caused by a fixed frequency division coefficient due to a limitation of a bit number of a timer. Therefore, in embodiments of the disclosure, accurately acquiring the PWM signal in each frequency range may be implemented.

**BRIEF DESCRIPTION OF THE DRAWINGS**

In order to explain the technical solutions in embodiments of the present disclosure more clearly, attached drawings described in the embodiments or in the related art will be briefly introduced below. Obviously, the diagrams described as below are only some embodiments of the present disclosure. Those skilled in the art may obtain other illustrative creative work.

FIG. 1 is a flowchart illustrating a method for acquiring a pulse width modulation (PWM) signal according to embodiments of the present disclosure;
FIG. 2 is a flowchart illustrating another method for acquiring a pulse width modulation (PWM) signal according to embodiments of the present disclosure;
FIG. 3 is a block diagram illustrating a structure of an apparatus for acquiring a pulse width modulation (PWM) signal according to embodiments of the present disclosure;
FIG. 4 is a diagram illustrating a structure of a computer device according to embodiments of the present disclosure.

**DETAILED DESCRIPTION**

In order to understand the above purpose, features and advantages of the present disclosure more clearly, the present disclosure may be further described in combination with attached drawings and embodiments. It may be understood that, embodiments are a part of embodiments of the disclosure, rather than all embodiments. The specific embodiments described here are merely used for explaining the present disclosure, rather than a limitation of embodiments of the present disclosure. On the basis of embodiments of the present disclosure, all other embodiments obtained by those skilled in the art are within the protection scope of the present disclosure.

It should be noted that relational terms such as "first" and "second" are used herein to distinguish one entity or operation from another entity or operation without necessarily requiring or implying any such actual relationship or order between such entities or operations.

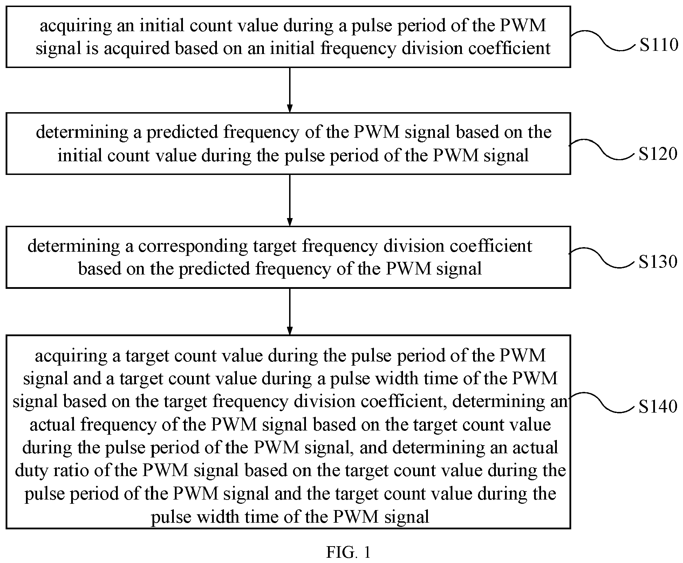

FIG. 1 is a flowchart illustrating a method for acquiring a pulse width modulation (PWM) signal according to embodiments of the present disclosure. As illustrated in FIG. 1, the method for acquiring the PWM signal includes S110 to S140.

At S110, an initial count value during a pulse period of the PWM signal is acquired based on an initial frequency division coefficient.

In embodiments of the disclosure, after detection of the PWM signal is started, the initial frequency division coefficient may be acquired first. The initial frequency division coefficient, may be, for example prestored by default. The initial frequency division coefficient generally limits a counting frequency of a timer. When count is performed during the pulse period of the PWM signal, a clock source is generally selected. A frequency of a clock source does not change, and a counting frequency may be determined based on the frequency of the clock source and the initial frequency division coefficient. The pulse period of the PWM signal refers to a period of one PWM signal, for example, a time between adjacent rising edges or a time between adjacent falling edges. The initial count value during the pulse period of the PWM signal refers to a corresponding count value within a time interval between two adjacent rising edges or two adjacent falling edges of the PWM signal based on the initial frequency division coefficient. The counting frequency indicates a counting speed of the timer. In the present disclosure, the counting frequency may be determined based on the initial frequency division coefficient, and an initial count value of the period of one PWM signal may be acquired based on the counting frequency.

At S120, a predicted frequency of the PWM signal is determined based on the initial count value during the pulse period of the PWM signal.

When the initial count value during the pulse period of the PWM signal is acquired based on the initial frequency division coefficient, the predicted frequency of the PWM signal may be obtained by predicting the frequency of the PWM signal based on the initial count value.

At S130, a corresponding target frequency division coefficient is determined based on the predicted frequency of the PWM signal.

The target frequency division coefficient corresponding to the predicted frequency of the PWM signal is searched based on the predicted frequency of the PWM signal determined at S120, so that the frequency division coefficient may be adjusted for PWM signals of different frequencies, and a corresponding target frequency division coefficient may be endowed.

At S140, a target count value during the pulse period of the PWM signal and a target count value during a pulse width time of the PWM signal are acquired based on the target frequency division coefficient, an actual frequency of the PWM signal is determined based on the target count value during the pulse period of the PWM signal, and an actual duty ratio of the PWM signal is determined based on the target count value during the pulse period of the PWM signal and the target count value during the pulse width time of the PWM signal.

After corresponding target frequency division coefficients are endowed for PWM signals of different frequencies, a count value is counted again based on the endowed target frequency division coefficient. That is, the target count value during the pulse period of the PWM signal and the target count value during the pulse width time of the PWM signal are acquired based on the target frequency division coefficient, the actual frequency of the PWM signal is determined based on the target count value during the pulse period of the PWM signal, and the actual duty ratio of the PWM signal is determined based on the target count value during the pulse period of the PWM signal and the target count value during the pulse width time of the PWM signal. The pulse width time of the PWM signal means an effective pulse width time in one pulse period of the PWM signal. For example, a high level of the PWM signal is an active pulse, then a duration of the high level in the one pulse period, i.e., a time between a rising edge and an adjacent falling edge is the pulse width time.

It should be noted that, the method for determining the actual frequency of the PWM signal based on the target count value during the pulse period of the PWM signal and determining the actual duty ratio of the PWM signal based on the target count value during the pulse period of the PWM signal and the target count value during the pulse width time of the PWM signal may adopt any existing method for calculating the actual frequency and the actual duty ratio of the PWM signal, which is not limited in embodiments of the present disclosure. Illustratively, for example, the target count value during the pulse period of the PWM signal acquired based on the target frequency division coefficient is X, the target count value during the pulse width time of the PWM signal acquired based on the target frequency division coefficient is Y, and the counting frequency of the timer is f based on the target frequency division coefficient, in this case, the actual frequency of the PWM signal is f/X, and the duty ratio of the PWM signal is Y/X.

In the disclosure, the frequency division coefficient may be self-adaptively adjusted based on the frequency of the input PWM signal, the target count value during the pulse period of the PWM signal and the target count value during the pulse width time of the PWM signal may be acquired based on the adjusted target frequency division coefficient, and the actual frequency of the PWM signal may be determined based on the target count value during the pulse period of the PWM signal, and the actual duty ratio of the PWM signal may be determined based on the target count value during the pulse period of the PWM signal and the target count value during the pulse width time of the PWM signal. Therefore, in embodiments of the disclosure, the PWM signal in each frequency range may be accurately acquired.

In an embodiment, in addition to a preset fixed initial frequency division coefficient, the initial frequency division coefficient may be determined based on an intermediate frequency of an acquisition frequency band of the PWM signal and the frequency of the clock source in embodiments of the disclosure.

When the rising edge or the falling edge of the PWM signal is captured, and the count value during the pulse period of the PWM signal is counted, one clock source generally needs to be selected, and the frequency of the clock source and the frequency division coefficient decide the count frequency. Since a frequency of the input PWM signal is unknown, in order to avoid affecting a calculation result caused by calculating the initial frequency division coefficient by using an over small frequency of the PWM signal or an over large frequency of the PWM signal, the initial frequency division coefficient is determined based on the intermediate frequency of the acquisition frequency band of the PWM signal and the frequency of the clock source in embodiments of the disclosure. For example, the acquisition frequency band of the PWM signal is 1Hz-10KHz, in this case, the initial frequency division coefficient may be determined based on a 5000HZ PWM signal and the frequency of the clock source.

In an embodiment, the initial frequency division coefficient may be determined based on an equation $Div0 = f1/(f2*N)$, where $f1$ is a frequency of a clock source, $f2$ is an intermediate frequency of an acquisition frequency band of the PWM signal, $DivO$ is an initial frequency division coefficient, and $N$ is a maximum count value of a timer.

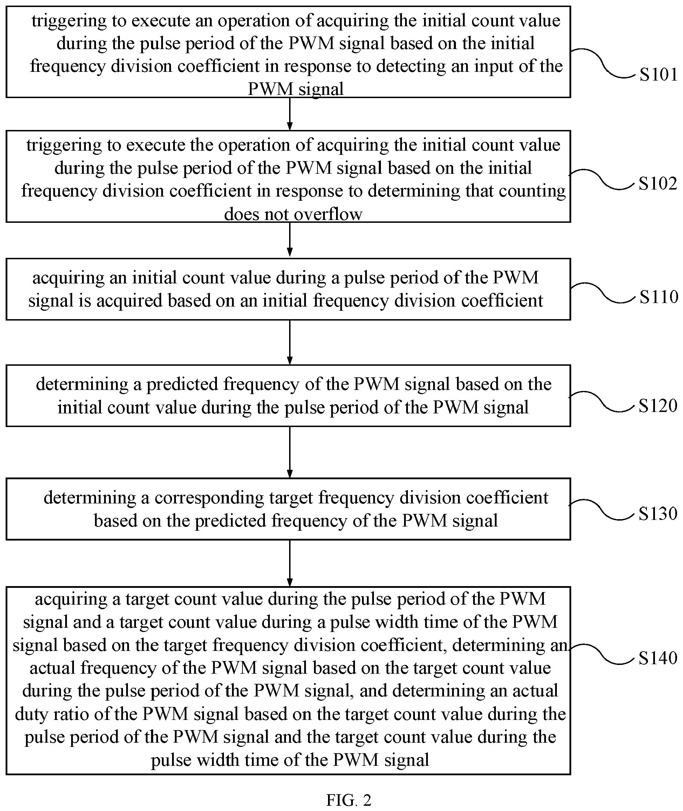

In an embodiment, as illustrated in FIG. 2, before acquiring the initial count value during the pulse period of the PWM signal based on the initial frequency division coefficient, the method may further include the following.

At S 101, an operation of acquiring the initial count value during the pulse period of the PWM signal based on the initial frequency division coefficient is triggered to be executed in response to detecting an input of the PWM signal.

In embodiments of the disclosure, it is first determined whether a function of capturing the PWM signal is activated, that is, it is detected whether there is an input of the PWM signal. The operation of acquiring the initial count value during the pulse period of the PWM signal based on the initial frequency division coefficient is triggered to be executed in response to determining the input of the PWM signal.

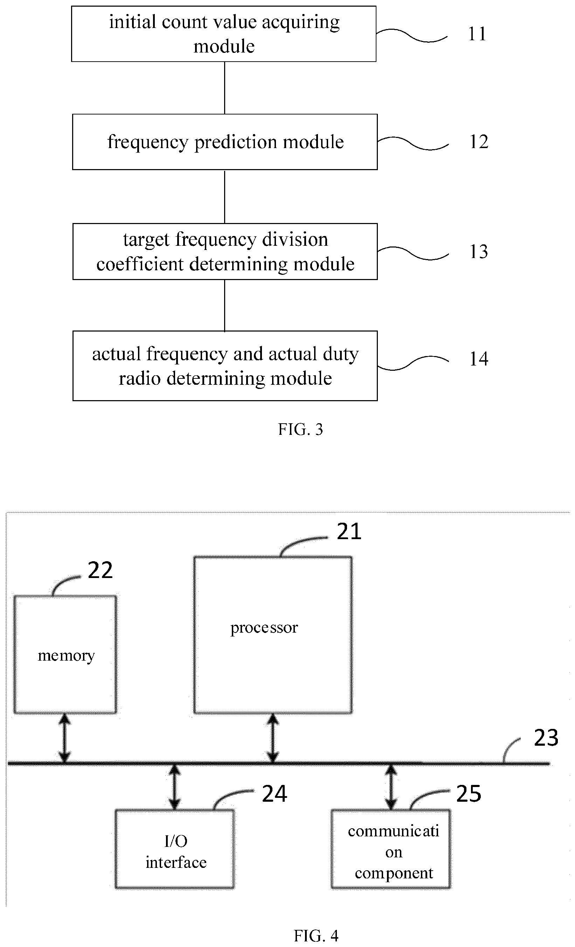

In an embodiment, as illustrated in FIG. 3, after detecting the input of the PWM signal, embodiments of the disclosure may further include the following.

At S102, the operation of acquiring the initial count value during the pulse period of the PWM signal based on the initial frequency division coefficient is triggered to be executed in response to determining that count does not overflow.

The timer will automatically clear to zero based on count overflow, and the count during the pulse period of the PWM signal cannot be adopted for subsequent calculation. Therefore, in embodiments of the disclosure, it is first determined whether the count overflows or not, and the operation of acquiring the initial count value during the pulse period of the PWM signal based on the initial frequency division coefficient is triggered to be executed in response to determining that count does not overflow.

In an embodiment, determining the corresponding target frequency division coefficient based on the predicted frequency of the PWM signal includes:

> determining a frequency band to which the predicted frequency of the PWM signal belongs; and
> determining a frequency division coefficient corresponding to the frequency band to which the predicted frequency of the PWM signal belongs as the target frequency division coefficient of the PWM signal.

In embodiments of the disclosure, a correspondence table between an acquisition frequency band of a PWM signal and a frequency division coefficient may be preset. For example, acquisition frequency bands of the PWM signal include a band 1, a band 2 and a band 3. The band 1 is 1HZ-500HZ, the band 2 is 501HZ-1000HZ, and the band 3 is 1001HZ-1500HZ. A frequency division coefficient corresponding to the band 1 is Div1 = 64, a frequency division coefficient corresponding to the band 2 is Div2 = 32, and a frequency division coefficient corresponding to the band 3 is Div3 = 1. The frequency band to which the predicted frequency of the PWM signal belongs is searched from a preset correspondence table between the acquisition frequency band of the PWM signal and the frequency division coefficient, and the frequency division coefficient corresponding to the frequency band to which the predicted frequency of the PWM signal belongs is determined as the target frequency division coefficient of the PWM signal. For example, the predicted frequency of the PWM signal is 800HZ, which belongs to the band 2, and the frequency division coefficient corresponding to the band 2 is 32, in this case, the target frequency division coefficient of the PWM signal is 32. The predicted frequency of the PWM signal is 100HZ, which belongs to the band 1, and the frequency division coefficient corresponding to the band 1 is 64, in this case, the target frequency division coefficient of the PWM signal is 64.

In an embodiment, before determining the frequency division coefficient corresponding to the frequency band to which the predicted frequency of the PWM signal belongs as the target frequency division coefficient of the PWM signal, the method may further include: triggering an operation of determining the frequency division coefficient corresponding to the frequency band to which the predicted frequency of the PWM signal belongs as the target frequency division coefficient of the PWM signal in response to determining that the frequency division coefficient corresponding to the frequency band to which the predicted frequency of the PWM signal belongs is different from the initial frequency division coefficient.

In embodiments of the disclosure, before determining the frequency division coefficient corresponding to the frequency band to which the predicted frequency of the PWM signal belongs as the target frequency division coefficient of the PWM signal, it is first determined whether the frequency division coefficient corresponding to the frequency band to which the predicted frequency of the PWM signal belongs is same as the initial frequency division coefficient. When the frequency division coefficient corresponding to the frequency band to which the predicted frequency of the PWM signal belongs is different from the initial frequency division coefficient, the frequency division coefficient is readjusted then, which avoids that counting statistics is performed again when the frequency division coefficient corresponding to the frequency band to which the predicted frequency of the PWM signal is the same as the initial frequency division coefficient.

Correspondingly, on the basic of the frequency division coefficient corresponding to the frequency band to which the predicted frequency of the PWM signal belongs being the same as the initial frequency division coefficient, the predicted frequency of the PWM signal is taken as the actual frequency of the PWM signal, and a predicted duty ratio of the PWM signal determined based on the initial count value during the pulse period of the PWM signal and the initial count value during the pulse width time of the PWM signal is taken as the actual duty ratio of the PWM signal. An initial count value during the pulse width time of the PWM signal is acquired based on the initial frequency division coefficient.

For example, the predicted frequency of the PWM signal is 300HZ, which belongs to the band 1 (1Hz-500Hz), the frequency division coefficient corresponding to the band 1 is 64. Based on the initial frequency division coefficient Div0= 64, the 300HZ predicted frequency of the PWM signal is directly taken as the actual frequency of the PWM signal without an operation of adjusting the frequency division coefficient. The predicted duty ratio of the PWM signal determined based on the initial count value during the pulse period of the PWM signal and the initial count value during the pulse width time of the PWM signal is taken as the actual duty ratio of the PWM signal, and the initial count value during the pulse width time of the PWM signal is acquired based on the initial frequency division coefficient DivO. In a case that the predicted frequency of the PWM signal is 800HZ, which belongs to the band 2 (501Hz-1000Hz), the frequency division coefficient corresponding to the band 2 is 32. The operation of adjusting the frequency division coefficient is required to be performed based on the initial frequency division coefficient Div0= 64, and the frequency division coefficient 32 corresponding to the frequency band to which the predicted frequency of the PWM signal 300HZ belongs is determined as the target frequency division coefficient of the PWM signal. In such a configuration, recounting by using the same frequency division coefficient may be avoided, and repetition operation may be avoided.

In an embodiment, the higher the predicted frequency of the PWM signal, the smaller the target frequency division coefficient.

For example, a correspondence between a predicted frequency of a PWM signal and a target frequency division coefficient may be preset. By verification, it is found the higher the predicted frequency of the PWM signal, the smaller the target frequency division coefficient, so that the acquired frequency of the PWM signal and the duty ratio are relatively accurate.

In an embodiment, acquiring the target count value during the pulse period of the PWM signal and the target count value during the pulse width time of the PWM signal based on the target frequency division coefficient, determining the actual frequency of the PWM signal based on the target count value during the pulse period of the PWM signal, and determining the actual duty ratio of the PWM signal based on the target count value during the pulse period of the PWM signal and the target count value during the pulse width time of the PWM signal includes:

acquiring the target count value during the pulse period of the PWM signal and the target count value during the pulse width time of the PWM signal based on the target frequency division coefficient; and discarding a target count value during the pulse period of the PWM signal acquired based on the target frequency division coefficient for a first time and a target count value during the pulse width time of the PWM signal acquired based on a target frequency division coefficient for a first time, determining the actual frequency of the PWM signal based on the target count value during the pulse period of the PWM signal acquired based on the target frequency division coefficient for a second time, and determining the actual duty ratio of the PWM signal based on the target count value during the pulse period of the PWM signal and the target count value during the pulse width time of the PWM signal acquired based on the target frequency division coefficient for the second time.

In embodiments of the disclosure, after the initial frequency division coefficient is adjusted to the target frequency division coefficient, abnormal counting may occur in a process of switching the frequency division coefficient. Therefore, in embodiments of the disclosure, after the initial frequency division coefficient is adjusted to the target frequency division coefficient, the target count value during the pulse period of the PWM signal acquired based on the target frequency division coefficient for the first time and the target count value during the pulse width time of the PWM signal acquired based on the target frequency division coefficient for the first time are discarded, the actual frequency of the PWM signal is determined based on the target count value during the pulse period of the PWM signal acquired based on the target frequency division coefficient for a second time, and the actual duty ratio of the PWM signal is determined based on the target count value during the pulse period of the PWM signal and the target count value during the pulse width time of the PWM signal acquired based on the target frequency division coefficient for a second time.

In an embodiment, acquiring the target count value during the pulse period of the PWM signal and the target count value during the pulse width time of the PWM signal based on the target frequency division coefficient, determining the actual frequency of the PWM signal based on the target count value during the pulse period of the PWM signal, and determining the actual duty ratio of the PWM signal based on the target count value during the pulse period of the PWM signal and the target count value during the pulse width time of the PWM signal includes:

acquiring the target count value during the pulse period of the PWM signal and the target count value during the pulse width time of the PWM signal based on the target frequency division coefficient;

acquiring the actual duty ratio of the PWM signal determined based on the target count value during the pulse period of the PWM signal acquired based on the target frequency division coefficient for the first time; and

in response to a difference value between the actual frequency of the PWM signal and the predicted frequency of the PWM signal being greater than a preset threshold, determining the actual frequency of the PWM signal based on a target count value during the pulse period of the PWM signal acquired based on the target frequency division coefficient for the second time, and determining the actual duty ratio of the PWM signal based on the target count value during the pulse period of the PWM signal and a target count value during the pulse width time of the PWM signal acquired based on the target frequency division coefficient for the second time.

In embodiments of the disclosure, after the initial frequency division coefficient is adjusted to the target frequency division coefficient, in order to avoid abnormal counting that may occur in the process of switching the frequency division coefficient, resulting in inaccurately acquiring the actual frequency of the PWM signal and the actual duty ratio of the PWM signal, and the actual duty ratio of the PWM signal determined based on the target count value during the pulse period of the PWM signal acquired based on the target frequency division coefficient for the first time may be compared with the predicted frequency of the PWM signal. When the difference value between the actual duty ratio of the PWM signal determined based on the target count value during the pulse period of the PWM signal acquired based on the target frequency division coefficient for the first time and the predicted frequency of the PWM signal is greater than the preset threshold, it indicates that the actual frequency of the PWM signal determined based on the target count value during the pulse period of the PWM signal acquired based on the target frequency division coefficient for the first time is inaccurate, the actual frequency of the PWM signal is determined based on the target count value during the pulse period of the PWM signal acquired based on the target frequency division coefficient for the second time, and the actual duty ratio of the PWM signal is determined based on the target count value during the pulse period of the PWM signal and the target count value during the pulse width time of the PWM signal acquired based on the target frequency division coefficient for the second time. When the difference value between the actual frequency of the PWM signal determined based on the target count value during the pulse period of the PWM signal acquired based on the target frequency division coefficient for the first time and the predicted frequency of the PWM signal is less than or equal to the preset threshold, the actual frequency of the PWM signal determined based on the target count value during the pulse period of the PWM signal acquired based on the target frequency division coefficient for the first time may be taken as a finally actual frequency of the PWM signal, and the actual duty ratio of the PWM signal determined based on the target count value during the pulse period of the PWM signal and the target count value during the pulse width time of the PWM signal acquired based on the target frequency division coefficient for the second time is taken as a final actual duty ratio of the PWM signal.

An apparatus for acquiring a pulse width modulation (PWM) signal is provided according to embodiments of the present disclosure. FIG. 3 is a block diagram illustrating a structure of an apparatus for acquiring a pulse width modulation (PWM) signal according to embodiments of the present disclosure, and includes an initial count value acquiring module 11, a frequency prediction module 12, a target frequency division coefficient determining module 13 and an actual frequency and actual duty radio determining module 14.

The initial count value acquiring module 11 is configured to acquire an initial count value during a pulse period of the PWM signal based on an initial frequency division coefficient. The frequency prediction module 12 is configured to determine a predicted frequency of the PWM signal based on the initial count value during the pulse period of the PWM signal. The target frequency division coefficient determining module 13 is configured to a corresponding target frequency division coefficient based on the predicted frequency of the PWM signal. The actual frequency and actual duty radio determining module 14 is configured to acquire a target count value during the pulse period of the PWM signal and a target count value during a pulse width time of the PWM signal based on the target frequency division coefficient, determine an actual frequency of the PWM signal based on the target count value during the pulse period of the PWM signal, and determine an actual duty ratio of the PWM signal based on the target count value during the pulse period of the PWM signal and the target count value during the pulse width time of the PWM signal.

It needs to be noted that, the foregoing explanation of the method embodiment for acquiring the PWM signal is also applicable to the apparatus embodiment for acquiring the PWM signal, which will not be repeated here. The specific way in which each module performs the operation in apparatus embodiments for acquiring the PWM signal has been described in the method embodiments and will not be elaborated here.

In an embodiment, the apparatus for acquiring the PWM signal further includes an initial frequency division determining module. The initial frequency division determining module is configured to determine the initial frequency division coefficient based on an intermediate frequency of an acquisition frequency band of the PWM signal and a frequency of a clock source. In an embodiment, the initial frequency division coefficient determining module is specifically configured to determine the initial frequency division coefficient based on an equation:

$$Div0 = f1/(f2*N);$$

where f1 is a frequency of a clock source, f2 is an intermediate frequency of an acquisition frequency band of the PWM signal, DivO is an initial frequency division coefficient, and N is a maximum count value of a timer.

In an embodiment, the apparatus for acquiring the PWM signal further includes a PWM signal input detection module. The PWM signal input detection module is configured to trigger the initial count value acquiring module to execute an operation of acquiring the initial count value during one PWM signal based on the initial frequency division coefficient in response to detecting an input of the PWM signal.

In an embodiment, the apparatus for acquiring the PWM signal further includes a count overflow determining module. The count overflow determining module is configured to trigger the initial count value acquiring module to execute the operation of acquiring the initial count value during one pulse period of the PWM signal based on the initial frequency division coefficient in response to determining that count does not overflow.

In an embodiment, the target frequency division coefficient determining module is specifically configured to determine a frequency band to which the predicted frequency of the PWM signal belongs; and determine the frequency division coefficient corresponding to the frequency band to which the predicted frequency of the PWM signal belongs as the target frequency division coefficient of the PWM signal.

In an embodiment, the apparatus for acquiring the PWM signal further includes a frequency division coefficient comparison module. The frequency division coefficient comparison module is configured to trigger an operation of determining the frequency division coefficient corresponding to the frequency band to which the predicted frequency of the PWM signal belongs as the target frequency division coefficient of the PWM signal in response to determining that the frequency division coefficient corresponding to the frequency band to which the predicted frequency of the PWM signal belongs is different from the initial frequency division coefficient.

In an embodiment, the frequency division coefficient comparison module is configured to, in response to determining that the frequency division coefficient corresponding to the frequency band to which the predicted frequency of the PWM signal belongs is same as the initial frequency division coefficient, trigger the actual frequency and actual duty ratio determining module to perform operations of taking the predicted frequency of the PWM signal as the actual frequency of the PWM signal, and taking the predicted duty ratio of the PWM signal determined based on the initial count value during the pulse period of the PWM signal to the initial count value during the pulse width time of the PWM signal as the actual duty ratio of the PWM signal.

The initial count value during the pulse period of the PWM signal is acquired based on the initial frequency division coefficient.

In an embodiment, the higher the predicted frequency of the PWM signal, the smaller the target frequency division coefficient.

In an embodiment, the actual frequency and actual duty ratio determining module is specifically configured to:

acquire the target count value during the pulse period of the PWM signal and the target count value during the pulse width time of the PWM signal based on the target frequency division coefficient; and
discard a target count value during the pulse period of the PWM signal acquired based on the target frequency division coefficient for a first time and a target count value during the pulse width time of the PWM signal acquired based on the target frequency division coefficient for a first time, determine the actual frequency of the PWM signal based on the target count value during the pulse period of the PWM signal acquired based on a target frequency division coefficient for a second time, and determine the actual duty ratio of the PWM signal based on the target count value during the pulse period of the PWM signal and the target count value during the pulse width time of the PWM signal acquired based on the target frequency division coefficient for the second time.

In an embodiment, the actual frequency and actual duty ratio determining module is specifically configured to:

acquire the target count value during the pulse period of the PWM signal and the target count value during the pulse width time of the PWM signal based on the target frequency division coefficient;
acquire the actual duty ratio of the PWM signal determined based on the target count value during the pulse period of the PWM signal acquired based on the target frequency division coefficient for the first time; and
in response to a difference value between the actual frequency of the PWM signal and the predicted frequency of the PWM signal being greater than a preset threshold, determine the actual frequency of the PWM signal based on a target count value during the pulse period of the PWM signal acquired based on the target frequency division coefficient for the second time, and determine the actual duty ratio of the PWM signal based on the target count value during the pulse period of the PWM signal and a target count value during the pulse width time of the PWM signal acquired based on the target frequency division coefficient for the second time.

A computer device including one or more processors and a storage device is further provided according to embodiments of the disclosure. The storage device is configured to store one or more programs. When the one or more programs are executed by the one or more processors, the one or more processors are caused to implement the method for acquiring the PWM signal as described in the first aspect of any embodiment.

FIG. 4 is a diagram illustrating a structure of a computer device according to embodiments of the present disclosure. FIG. 5 is a block diagram illustrating an exemplary computer device configured to implement the embodiment of the present disclosure. The computer device as illustrated in FIG. 4 is only an example and should not bring any limitation on the function or application range of the embodiment.

As illustrated in FIG. 4, components of the computer device 12 may include but not limited to one or more processors 21, a memory 22, and a bus 23 connected to different system components. In some embodiments, the computer device may further include one or more of an input/output (I/O) interface 24, and a communication component 25.

The bus 23 represents one or more of several types of bus structures, including a memory bus or a memory controller, a peripheral bus, a graphics acceleration port, a processor, or a local bus with any of a plurality of bus structures. For example, the architectures include, but are not limited to, an industry standard architecture (ISA) bus, a micro channel architecture (MAC) bus, an enhanced ISA bus, a video electronics standards association (hereinafter referred to as VESA) local bus and a peripheral component interconnection (PCI) bus.

In some implementation solutions, the computer device includes a variety of computer system readable media. The media may be any available media that may be accessed by the computer device, including volatile and non-volatile media, and removable and non-removable media.

The memory 22 may include a computer system readable medium in the form of a volatile memory, for example, a random access memory (RAM) and/or a cache memory. The computer device may further include other volatile and non-volatile media, and removable and non-removable media. As an example only, a storage system may be configured to read and write a non-removable and non-volatile magnetic medium (not shown in FIG. 4, commonly referred to as a "hard disk drive"). Although not illustrated in FIG. 4, a disk drive for reading and writing a removable non-volatile magnetic disk (for example, a "floppy disk"), and an optical disk drive for reading and writing a removable non-volatile optical disk (such as a compact disc read only memory (CD-ROM)) or other optical media) may be provided. In these cases, each driver may be connected to the bus 23 through one or more data media interfaces. The memory 22 may include at least one program product having a set (for example, at least one) program modules configured to perform functions of embodiments of the present disclosure.

A computer-readable storage medium with a computer program stored thereon is provided according to embodiments of the disclosure. The computer program implements the method for acquiring the PWM signal as described in any embodiment of the present disclosure when executed by a processor.

A computer program product including a computer program is further provided according to embodiments of the disclosure. When the computer program is executed by a processor, the method for acquiring the PWM signal as described in the first aspect of any embodiment of the present disclosure is implemented.

A computer program including a computer program code is further provided according to embodiments of the disclosure. When the computer program code is running on a computer, the computer is caused to perform the method for acquiring the PWM signal as described in the first aspect of any embodiment of the present disclosure.

It needs to be noted that, the foregoing explanation of the method embodiments and the apparatus embodiments is also applicable to the device, the computer-readable storage medium, the computer program product and the computer program, which will not be repeated here.

In the above embodiments, functions may be wholly or partially implemented by a software, a hardware, a firmware, or any combination thereof. When implemented by a software, the functions may be implemented in whole or in part in the form of a computer program product. The computer program product includes one or more computer instructions. Procedures or functions according to embodiments of the present disclosure are wholly or partially generated when the computer program instruction is loaded and executed on a computer.

Any reference to a memory, a database or other media used in embodiments provided in the application may include at least one of a non-volatile memory or a volatile memory. The non-volatile memory may include a read-only memory (ROM), a magnetic disk, a floppy disk, an optical disk or an optical memory. The volatile memory may include a random access memory (RAM) or an external high-speed cache memory. As an illustration rather than a limitation, the RAM is available in a plurality of forms, such as a static random access memory (SRAM) and a dynamic random access memory (DRAM).

Technical features of the above embodiments may be combined arbitrarily. For the purpose of a brief description, all possible combinations of the technical features of the above embodiments are not described. However, as long as there is no contradiction in the combination of the technical features, it shall be deemed to be the scope of the description.

The above embodiments only express several implementations of the disclosure, and the description is specific and detailed, but it cannot be understood as a limitation of the scope of the invention patent. It should be noted that, for those skilled in the art, several improvements and modifications may be made without departing from the principles of the present disclosure, and these improvements and modifications are also considered to be within the protection scope of the present disclosure. Therefore, the protection scope of the present disclosure shall be subject to the protection scope of claims.

All embodiments of the disclosure may be executed separately or in combination with other embodiments, and are deemed within a protection scope of the disclosure.

## Claims

1. A method for acquiring a pulse width modulation (PWM) signal, comprising:

   acquiring an initial count value during a pulse period of the PWM signal based on an initial frequency division coefficient;
   determining a predicted frequency of the PWM signal based on the initial count value during the pulse period of the PWM signal;
   determining a corresponding target frequency division coefficient based on the predicted frequency of the PWM signal; and
   acquiring a target count value during the pulse period of the PWM signal and a target count value during a pulse width time of the PWM signal based on the target frequency division coefficient, determining an actual frequency of the PWM signal based on the target count value during the pulse period of the PWM signal, and determining an actual duty ratio of the PWM signal based on the target count value during the pulse period of the PWM signal and the target count value during the pulse width time of the PWM signal.

2. The method according to claim 1, wherein the initial frequency division coefficient is determined based on an intermediate frequency of an acquisition frequency band of the PWM signal and a frequency of a clock source.

3. The method according to claim 1 or 2, wherein the initial frequency division coefficient is determined based on an equation:

$$Div0 = f1/(f2*N);$$

where f1 is a frequency of a clock source, f2 is an intermediate frequency of an acquisition frequency band of the PWM signal, DivO is an initial frequency division coefficient, and N is a maximum count value of a timer.

4. The method according to any one of claims 1 to 3, wherein before acquiring the initial count value during the pulse period of the PWM signal based on the initial frequency division coefficient, the method further comprises:
   triggering to execute an operation of acquiring the initial count value during the pulse period of the PWM signal based on the initial frequency division coefficient in response to detecting an input of the PWM signal.

5. The method according to claim 4, wherein after detecting the input of the PWM signal, the method further comprises:
   triggering to execute the operation of acquiring the initial count value during the pulse period of the PWM signal based on the initial frequency division coefficient in response to determining that count does not overflow.

6. The method according to any one of claims 1 to 5, wherein determining the corresponding target frequency division coefficient based on the predicted frequency of the PWM signal comprises:

   determining a frequency band to which the predicted frequency of the PWM signal belongs; and
   determining a frequency division coefficient corresponding to the frequency band to which the predicted frequency of the PWM signal belongs as the target frequency division coefficient of the PWM signal.

7. The method according to claim 6, wherein before determining the frequency division coefficient corresponding to the frequency band to which the predicted frequency of the PWM signal belongs as the target frequency division coefficient of the PWM signal, the method comprises:
   triggering an operation of determining the frequency division coefficient corresponding to the frequency band to which the predicted frequency of the PWM signal belongs as the target frequency division coefficient of the PWM signal in response to determining that the frequency division coefficient corresponding to the frequency band to which the predicted frequency of the PWM signal belongs is different from the initial frequency division coefficient.

8. The method according to any one of claims 1 to 7, wherein acquiring the target count value during the pulse period of the PWM signal and the target count value during the pulse width time of the PWM signal based on the target frequency division coefficient, determining the actual frequency of the PWM signal based on the target count value during the pulse period of the PWM signal, and determining the actual duty ratio of the PWM signal based on the target count value during the pulse period of the PWM signal and the target count value during the pulse width time of the PWM signal comprises:

acquiring the target count value during the pulse period of the PWM signal and the target count value during the pulse width time of the PWM signal based on the target frequency division coefficient; and

discarding a target count value during the pulse period of the PWM signal acquired based on the target frequency division coefficient for a first time and a target count value during the pulse width time of the PWM signal acquired based on the target frequency division coefficient for a first time, determining the actual frequency of the PWM signal based on a target count value during the pulse period of the PWM signal acquired based on the target frequency division coefficient for a second time, and determining the actual duty ratio of the PWM signal based on the target count value during the pulse period of the PWM signal and the target count value during the pulse width time of the PWM signal acquired based on the target frequency division coefficient for the second time.

9. The method according to claim 8, wherein acquiring the target count value during the pulse period of the PWM signal and the target count value during the pulse width time of the PWM signal based on the target frequency division coefficient, determining the actual frequency of the PWM signal based on the target count value during the pulse period of the PWM signal, and determining the actual duty ratio of the PWM signal based on the target count value during the pulse period of the PWM signal and the target count value during the pulse width time of the PWM signal comprises:

acquiring the target count value during the pulse period of the PWM signal and the target count value during the pulse width time of the PWM signal based on the target frequency division coefficient;

acquiring the actual duty ratio of the PWM signal determined based on the target count value during the pulse period of the PWM signal acquired based on the target frequency division coefficient for the first time; and

in response to a difference value between the actual frequency of the PWM signal and the predicted frequency of the PWM signal being greater than a preset threshold, determining the actual frequency of the PWM signal based on a target count value during the pulse period of the PWM signal acquired based on the target frequency division coefficient for the second time, and determining the actual duty ratio of the PWM signal based on the target count value during the pulse period of the PWM signal and a target count value during the pulse width time of the PWM signal acquired based on the target frequency division coefficient for the second time.

10. An apparatus for acquiring a pulse width modulation (PWM) signal, comprising:

an initial count value acquiring module, configured to acquire an initial count value during a pulse period of the PWM signal based on an initial frequency division coefficient;

a frequency prediction module, configured to determine a predicted frequency of the PWM signal based on the initial count value during the pulse period of the PWM signal;

a target frequency division coefficient determining module, configured to determine a corresponding target frequency division coefficient based on the predicted frequency of the PWM signal; and

an actual frequency and actual duty radio determining module, configured to acquire a target count value during the pulse period of the PWM signal and a target count value during a pulse width time of the PWM signal based on the target frequency division coefficient, determine an actual frequency of the PWM signal based on the target count value during the pulse period of the PWM signal, and determine an actual duty ratio of the PWM signal based on the target count value during the pulse period of the PWM signal and the target count value during the pulse width time of the PWM signal.

11. A computer device, comprising one or more processors and a storage device;

wherein the storage device is configured to store one or more programs, wherein when the one or more programs are executed by the one or more processors, the one or more processors are caused to implement the method according to any one of claims 1 to 9.

12. A computer-readable storage medium with a computer program stored thereon, wherein the computer program is configured to implement the method according to any one of claims 1 to 9 when executed by a processor.

**13.** A computer program product comprising a computer program, wherein the computer program implements the method according to any one of claims 1 to 9 when executed by a processor.

**14.** A computer program, comprising a computer program code, wherein when the computer program code runs on a computer, the computer is caused to perform the method according to any one of claims 1 to 9.

```
┌─────────────────────────────────────────────────────┐
│  acquiring an initial count value during a pulse period of the PWM
│  signal is acquired based on an initial frequency division coefficient │ ──── S110
└─────────────────────────────────────────────────────┘
                            │
                            ▼
┌─────────────────────────────────────────────────────┐
│  determining a predicted frequency of the PWM signal based on the
│  initial count value during the pulse period of the PWM signal        │ ──── S120
└─────────────────────────────────────────────────────┘
                            │
                            ▼
┌─────────────────────────────────────────────────────┐
│  determining a corresponding target frequency division coefficient
│  based on the predicted frequency of the PWM signal                   │ ──── S130
└─────────────────────────────────────────────────────┘
                            │
                            ▼
┌─────────────────────────────────────────────────────┐
│  acquiring a target count value during the pulse period of the PWM
│  signal and a target count value during a pulse width time of the PWM
│  signal based on the target frequency division coefficient, determining an │ ──── S140
│  actual frequency of the PWM signal based on the target count value
│  during the pulse period of the PWM signal, and determining an actual
│  duty ratio of the PWM signal based on the target count value during the
│  pulse period of the PWM signal and the target count value during the
│  pulse width time of the PWM signal                                   │
└─────────────────────────────────────────────────────┘
```

FIG. 1

```
┌─────────────────────────────────────────────────────────┐
│  triggering to execute an operation of acquiring the      │
│  initial count value during the pulse period of the PWM   │╲
│  signal based on the initial frequency division           │  ╲____ S101
│  coefficient in response to detecting an input of the     │
│  PWM signal                                               │
└─────────────────────────────────────────────────────────┘
                            │
                            ▼
┌─────────────────────────────────────────────────────────┐
│  triggering to execute the operation of acquiring the     │
│  initial count value during the pulse period of the PWM   │╲
│  signal based on the initial frequency division           │  ╲____ S102
│  coefficient in response to determining that counting     │
│  does not overflow                                        │
└─────────────────────────────────────────────────────────┘
                            │
                            ▼
┌─────────────────────────────────────────────────────────┐
│  acquiring an initial count value during a pulse period   │╲
│  of the PWM signal is acquired based on an initial         │  ╲____ S110
│  frequency division coefficient                           │
└─────────────────────────────────────────────────────────┘
                            │
                            ▼
┌─────────────────────────────────────────────────────────┐
│  determining a predicted frequency of the PWM signal      │╲
│  based on the initial count value during the pulse        │  ╲____ S120
│  period of the PWM signal                                 │
└─────────────────────────────────────────────────────────┘
                            │
                            ▼
┌─────────────────────────────────────────────────────────┐
│  determining a corresponding target frequency division    │╲
│  coefficient based on the predicted frequency of the      │  ╲____ S130
│  PWM signal                                               │
└─────────────────────────────────────────────────────────┘
                            │
                            ▼
┌─────────────────────────────────────────────────────────┐
│  acquiring a target count value during the pulse period   │
│  of the PWM signal and a target count value during a      │
│  pulse width time of the PWM signal based on the target   │
│  frequency division coefficient, determining an           │╲
│  actual frequency of the PWM signal based on the target   │  ╲____ S140
│  count value during the pulse period of the PWM signal,   │
│  and determining an actual duty ratio of the PWM signal   │
│  based on the target count value during the pulse period  │
│  of the PWM signal and the target count value during the  │
│  pulse width time of the PWM signal                       │
└─────────────────────────────────────────────────────────┘
```

FIG. 2

initial count value acquiring module — 11

frequency prediction module — 12

target frequency division coefficient determining module — 13

actual frequency and actual duty radio determining module — 14

FIG. 3

memory 22

processor 21

23

I/O interface 24

communication component 25

FIG. 4

## INTERNATIONAL SEARCH REPORT

International application No.

**PCT/CN2022/117112**

### A. CLASSIFICATION OF SUBJECT MATTER

G01R 29/02(2006.01)i;  G01R 23/10(2006.01)i

According to International Patent Classification (IPC) or to both national classification and IPC

### B. FIELDS SEARCHED

Minimum documentation searched (classification system followed by classification symbols)

G01R23; G01R29

Documentation searched other than minimum documentation to the extent that such documents are included in the fields searched

Electronic data base consulted during the international search (name of data base and, where practicable, search terms used)

CNABS, CNTXT, CNKI, VEN: PWM, 脉宽调制, 脉冲宽度调制, 频率, 占空比, 分频系数, 计数, PULSE, WIDE, FREQUENCY, DIVIDE, COUNTT

### C. DOCUMENTS CONSIDERED TO BE RELEVANT

| Category* | Citation of document, with indication, where appropriate, of the relevant passages | Relevant to claim No. |
|---|---|---|
| PX | CN 113933601 A (BEIJING CHJ INFORMATION TECHNOLOGY CO., LTD.) 14 January 2022 (2022-01-14)<br>claims 1-12 | 1-14 |
| A | CN 109412582 A (ZHUHAI AMICRO SEMICONDUCTOR CO., LTD.) 01 March 2019 (2019-03-01)<br>description, paragraphs 5-16, and figure 1 | 1-14 |
| A | CN 112242828 A (SHENZHEN 3IROBOTIX CO., LTD.) 19 January 2021 (2021-01-19)<br>entire document | 1-14 |
| A | CN 106571692 A (NEWEDGE TECHNOLOGY CO., LTD.) 19 April 2017 (2017-04-19)<br>entire document | 1-14 |
| A | CN 103368538 A (STATE GRID CORPORATION OF CHINA et al.) 23 October 2013 (2013-10-23)<br>entire document | 1-14 |
| A | CN 107835001 A (SHANGHAI CHENZHU INSTRUMENT CO., LTD.) 23 March 2018 (2018-03-23)<br>entire document | 1-14 |

☑ Further documents are listed in the continuation of Box C.　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **23 November 2022** | **30 November 2022** |

| Name and mailing address of the ISA/CN | Authorized officer |
|---|---|
| **China National Intellectual Property Administration (ISA/CN)**<br>**No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**

| International application No. |
| --- |
| **PCT/CN2022/117112** |

**C.  DOCUMENTS CONSIDERED TO BE RELEVANT**

| Category* | Citation of document, with indication, where appropriate, of the relevant passages | Relevant to claim No. |
| --- | --- | --- |
| A | CN 108736865 A (SAMSUNG ELECTRO-MECHANICS CO., LTD.) 02 November 2018 (2018-11-02)<br>  entire document | 1-14 |
| A | CN 109406876 A (CHENGDU LANDTOP TECHNOLOGY CO., LTD.) 01 March 2019 (2019-03-01)<br>  entire document | 1-14 |
| A | CN 112505410 A (JIANGHAN UNIVERSITY) 16 March 2021 (2021-03-16)<br>  entire document | 1-14 |
| A | CN 102539914 A (JIANGSU LVYANG ELECTRONIC INSTRUMENT GROUP CO., LTD.) 04 July 2012 (2012-07-04)<br>  entire document | 1-14 |
| A | JP 60214609 A (HITACHI LTD.) 26 October 1985 (1985-10-26)<br>  entire document | 1-14 |
| A | JP 05304780 A (YASKAWA ELECTRIC CORP.) 16 November 1993 (1993-11-16)<br>  entire document | 1-14 |

Form PCT/ISA/210 (second sheet) (January 2015)

## INTERNATIONAL SEARCH REPORT
### Information on patent family members

International application No.

**PCT/CN2022/117112**

| Patent document cited in search report | | | Publication date (day/month/year) | Patent family member(s) | | | Publication date (day/month/year) |
|---|---|---|---|---|---|---|---|
| CN | 113933601 | A | 14 January 2022 | None | | | |
| CN | 109412582 | A | 01 March 2019 | None | | | |
| CN | 112242828 | A | 19 January 2021 | None | | | |
| CN | 106571692 | A | 19 April 2017 | None | | | |
| CN | 103368538 | A | 23 October 2013 | None | | | |
| CN | 107835001 | A | 23 March 2018 | None | | | |
| CN | 108736865 | A | 02 November 2018 | US | 2018302078 | A1 | 18 October 2018 |
| | | | | KR | 20180115560 | A | 23 October 2018 |
| CN | 109406876 | A | 01 March 2019 | None | | | |
| CN | 112505410 | A | 16 March 2021 | None | | | |
| CN | 102539914 | A | 04 July 2012 | None | | | |
| JP | 60214609 | A | 26 October 1985 | None | | | |
| JP | 05304780 | A | 16 November 1993 | None | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 202111070278 A